Europäisches Patentamt

European Patent Office

Office européen des brevets

(19)

(11) Publication number: **0 348 916**

**A2**

(12) # EUROPEAN PATENT APPLICATION

(21) Application number: **89111707.9**

(22) Date of filing: **27.06.89**

(51) Int. Cl.4: **H01L 29/78**

The title of the invention has been amended (Guidelines for Examination in the EPO, A-III, 7.3).

(30) Priority: **27.06.88 JP 158317/88**

(43) Date of publication of application:
**03.01.90 Bulletin 90/01**

(84) Designated Contracting States:
**DE GB**

(71) Applicant: **NISSAN MOTOR CO., LTD.**
**No.2, Takara-cho, Kanagawa-ku**
**Yokohama-shi Kanagawa-ken 221(JP)**

(72) Inventor: **Murakami, Yoshinori**
**3-68 Oppamahigashi-cho**
**Yokosuka-shi Kanagawa-ken(JP)**
Inventor: **Mihara, Teruyoshi**
**4-10-8 Ohyabe Yokosuka-shi**
**kanagawa-ken(JP)**

(74) Representative: **Patentanwälte Grünecker, Kinkeldey, Stockmair & Partner**
**Maximilianstrasse 58**
**D-8000 München 22(DE)**

(54) **MOSFET equivalent voltage drive semiconductor device.**

(57) A semiconductor device including a semiconductor substrate having a first conductivity type, in which a metal electrode is formed on the semiconductor substrate to form a Schottky junction therebetween, and a gate electrode is arranged adjacent to the Schottky junction via an insulating film.

**FIG.2**

**EP 0 348 916 A2**

## SEMICONDUCTOR DEVICE

### BACKGROUND OF THE INVENTION

#### Field of the Invention

The present invention relates to a semiconductor device, and more particularly to a voltage drive semiconductor device equivalent to a MOSFET.

#### Description of the Background Art

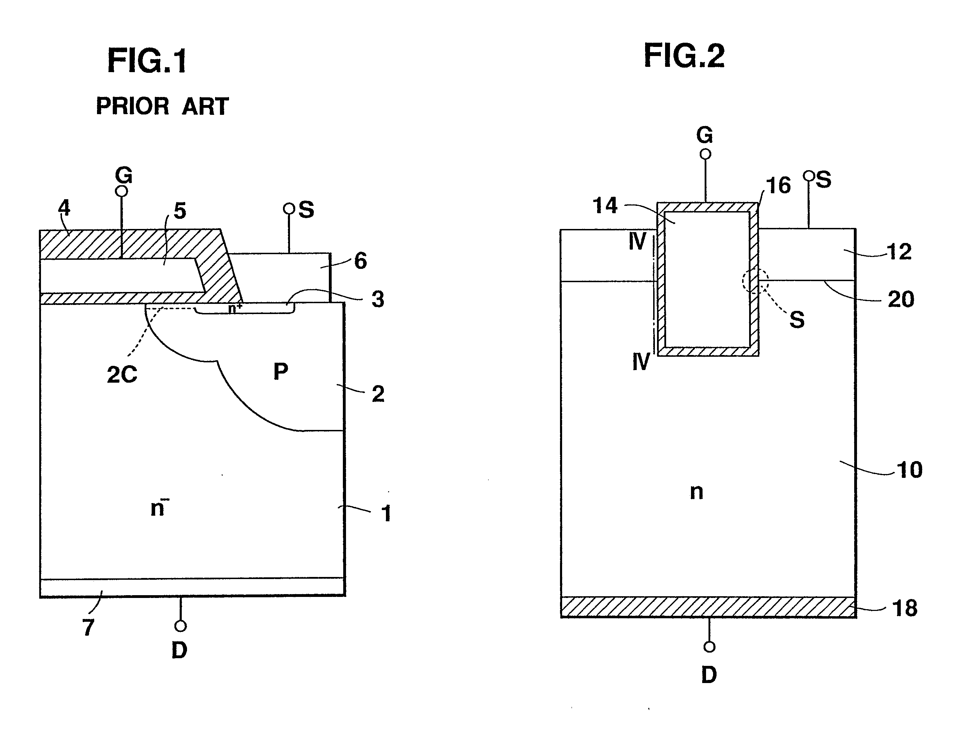

In Fig. 1, there is shown a conventional vertical n-channel MOSFET as a voltage drive transistor, to be mainly used as a power device. The vertical n-channel MOSFET includes an $n^-$-type drain region 1, a p-type channel region 2 formed therein, an $n^+$-type source region 3 formed in the surface area of the channel region 2, a gate electrode 5 covered by a gate oxide film 4, formed on the drain and source regions 1 and 3 via the gate oxide film 4, a source electrode 6 formed on the channel and source regions 2 and 3, and a drain electrode 7 attached to the bottom of the drain region 1. When the MOSFET of this kind is used, usually, the source electrode 6 is connected to the ground, and a positive voltage is applied to the drain electrode 7.

In this MOSFET, when no voltage is applied to the gate electrode 5, the junction between the drain and channel regions 1 and 2 is reverse-biased, and no current flows between the drain and source regions 1 and 3. In turn, when a certain positive voltage is applied to the gate electrode 5, an inversion layer 2c is caused in the surface area of the channel region 2 directly under the gate electrode 5, and electrons flow from the source region 3 to the drain region 1 through the inversion layer 2c.

As described above, a MOSFET is a so-called voltage drive device which is driven by a variation of its gate voltage, and can be driven at a high speed and a low energy, in comparison with a bipolar transistor of a current-drive device. Accordingly, the MOSFET is widely used in a variety applications.

However, the MOSFET has problems. Firstly, as shown in Fig. 1, the MOSFET includes an npn transistor composed of the drain, channel and source regions 1, 2 and 3 as a parasitic device. In the OFF condition that no voltage is applied to the gate electrode 5, when an avalanche breakdown takes place in the pn junction between the drain and channel regions 1 and 2, a hole current flows in the channel region 2 corresponding to the base of the parasitic transistor, and the parasitic transistor is actuated, resulting in a danger or fear of which the parasitic transistor is actuated and the current flowing in the device can not be correctly controlled.

Secondly, since a narrow region of an inversion layer as a channel is formed in a part of the channel region to flow a carrier therein, there is a relatively large channel resistance. This channel resistance becomes one factor of which an ON resistance of the MOSFET can not be reduced.

### SUMMARY OF THE INVENTION

Accordingly, it is an object of the present invention to provide a semiconductor device, free from the aforementioned defects and disadvantages of the prior art, which possesses a high resisting voltage, a low ON-resistance and a high current density.

It is another object of the present invention to provide a voltage drive semiconductor device equivalent to a MOSFET, which has a high resisting voltage, a low ON-resistance and a high current density, which can be produced in a simpler process.

In accordance with one aspect of the present invention, there is provided a semiconductor device comprising a semiconductor substrate having a first conductivity type, a metal electrode formed on the semiconductor substrate to form a Schottky junction therebetween, and a gate electrode arranged adjacent to the Schottky junction via an insulating film.

### BRIEF DESCRIPTION OF THE DRAWINGS

The above and other objects, features and advantages of the present invention will more fully appear from the following description of the preferred embodiments with reference to the accompanying drawings, in which:

Fig. 1 is a cross sectional view of a conventional vertical n-channel MOSFET;

Fig. 2 is a cross sectional view of a semiconductor device according to the present invention;

Fig. 3 is an enlarged fragmentary explanatory view of a portion S of a Schottky junction adjacent to a gate electrode via an insulating oxide film, shown in fig. 2;

Figs. 4a and 4b show energy bands along the line IV -IV shown in Fig. 2;

Fig. 5 schematically shows current-voltage characteristics of the semiconductor device shown in Fig. 2;

Figs. 6a to 6d are schematic views showing energy bands of a Schottky junction between an n-type silicon and a metallic electrode according to the present invention;

Figs. 7a to 7d are cross sectional views showing one embodiment of a method for producing the semiconductor device shown in Fig. 2; and

Figs. 8 and 9 are cross sectional views of other embodiments of a semiconductor device according to the present invention.

## DESCRIPTION OF THE PREFERRED EMBODIMENTS

Referring now to the drawings, wherein like reference characters designate like or corresponding parts throughout the several view and thus the repeated description thereof can be omitted for the brevity, there is shown in Fig. 2 one embodiment of a semiconductor device according to the present invention.

In the drawing, a source electrode 12 composed of a metallic material such as aluminum is formed on an n-type drain region 10 of a silicon semiconductor substrate having a first conductivity type to form a Schottky junction 20 therebetween. A gate electrode 14 is entirely covered by an insulating oxide film 16 and projects along therewith downwards into the upper portion of the drain region 10 and upwards outside across the source electrode 12. A drain electrode 18 is attached to the bottom of the drain region 10.

As regards the thickness of the insulating oxide film 16, it is preferably thinner for actuating a sufficient electric field to the silicon drain region 10, and, meanwhile, it is preferably thicker for obtaining a sufficient insulating resistant pressure between the source and gate electrodes 12 and 14. Accordingly, it is determined to a suitable thickness, e.g., 200 to 500 angstrom to properly satisfy these conditions.

When this semiconductor device is used, the source electrode 12 is connected to the ground, and a positive voltage $V_{DS}$ is applied to the drain electrode 18.

In this embodiment, when the gate electrode 14 is connected to the ground, the semiconductor device has the same reverse bias characteristics as those of a usual Schottky diode. Hence, no current flows between the drain region 10 and source electrode 12 until the drain voltage $V_{DS}$ becomes a sufficiently high voltage $V_B$. When the drain voltage $V_{DS}$ becomes larger than the $V_B$, the tunnel phenomenon is caused, and a current is started to rapidly flow between the drain region 10 and source electrode 12. In the case where the impurity concentration of the silicon constituting the drain region 10 is relatively low, an avalanche breakdown is caused at a certain voltage before the tunnel phenomenon is caused, and a current is started to flow between the drain region 10 and source electrode 12.

Accordingly, in the semiconductor device of the present invention, the drain voltage $V_{DS}$ is maintained to less than the relatively high voltage $V_B$, and in this condition, by selectively applying a positive voltage to the gate electrode 14, the control of the current flowing between the drain region 10 and source electrode 12.

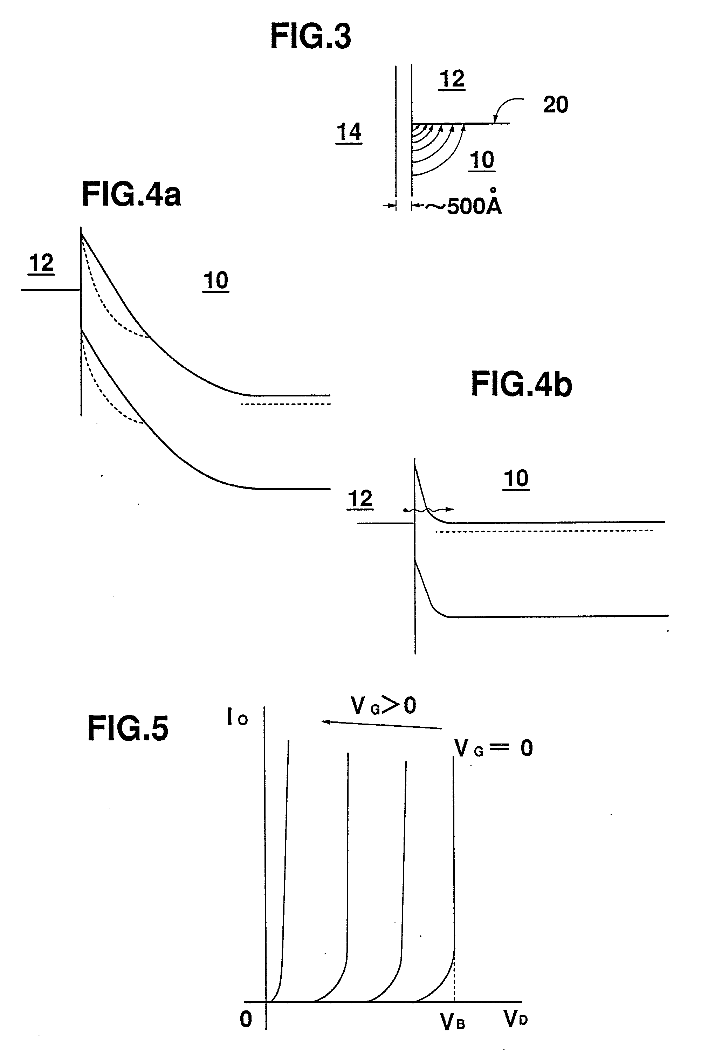

When the positive voltage is applied to the gate electrode 14, a strong electric field is partially affected to a region S of the Schottky junction 20 adjacent to the gate electrode 14, as shown in Fig. 3, and an apparent thickness of a barrier layer composed of the Schottky junction 20 is reduced due to the electric field concentration. Hence, even when the drain voltage $V_{DS}$ is less than the certain voltage $V_B$, the tunnel phenomenon is caused, and the current is started to flow between the drain region 10 and source electrode 12. In Fig. 2, a one-dotted line IV-IV indicates a linear area which extends parallel with the insulating oxide film 16 across the Schottky junction 20 and is slightly apart from the insulating oxide film 16.

Figs. 4a and 4b show the energy bands of the linear area IV-IV in Fig. 2. In Fig. 4a, the solid lines are obtained when the drain voltage $V_{DS}$ less than the certain voltage $V_B$ is applied in the device ($V_B < V_{DS} < 0$) and the gate electrode 14 is connected to the ground. The broken lines are obtained when a positive voltage is applied to the gate electrode 14.

In the operation of the device, the drain voltage $V_{DS}$ is lower than the gate voltage $V_G$, and an electron accumulation layer can be sometimes formed around the gate electrode 14. In such a case, as shown in Fig. 4b, in the electric field concentration region of the Schottky junction 20 adjacent to the gate electrode 14, the thickness of the barrier layer of the Schottky junction 20 is reduced by the accumulated electrons, and the tunnel current is continuously flowed. Hence, the voltage of the accumulation layer around the gate electrode 14 becomes equal to the voltage of the source electrode 12, and, even when the voltage $c_i$ the drain region 10 becomes lower than that of the gate electrode 14, the current keeps on flowing.

In this case, such a current flowing area caused by the reduction of the barrier layer of the Schottky junction 20 due to the electric field concentration, is several tens of angstrom. However, by applying a sufficiently high voltage to the gate electrode 14 or miniaturizing a gate structure, a device having a sufficiently low ON-resistance can be realized. The current-voltage characteristics of the device are schematically shown in Fig. 5, wherein $V_G$ is the gate voltage.

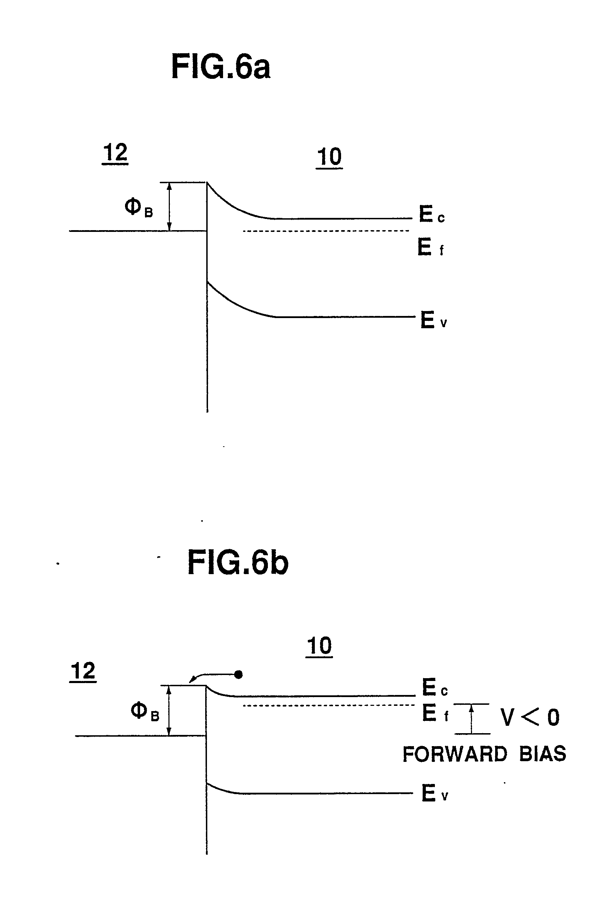

The characteristics of the Schottky junction of the semiconductor device according to the present invention will be described in detail in connection with Figs. 6a to 6d.

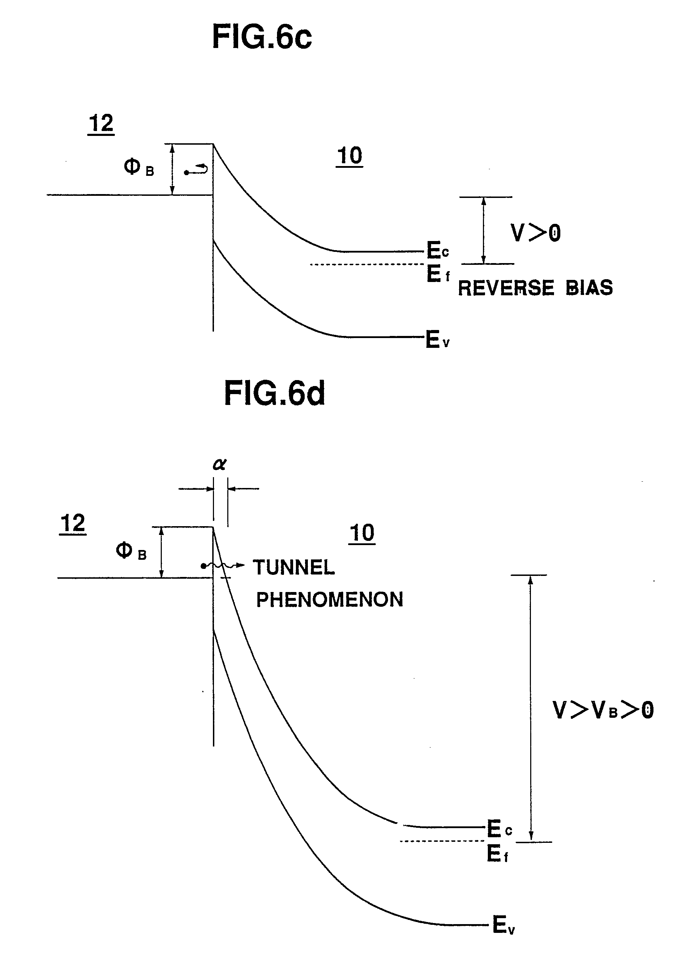

In Fig. 6a, there is shown an energy band of the Schottky junction between the drain region of the n-type silicon and the source electrode 12 of the metal. There exists an energy barrier $\phi_B$ in the junction between these two members according to a difference between the work functions thereof. When the metal side is forward-biased, as shown in Fig. 6b, the electronic current flows from the silicon side to the metal side. On the other hand, when the metal side is reverse-biased, as shown in Fig. 6c, the electrons of the metal side can not clear the energy barrier $\phi_B$, and the current hardly flows. However, when a sufficiently large reverse-bias is given to the metal side, as shown in Fig. 6d, the thickness of the energy barrier is reduced, and the current flows due to the tunnel phenomenon. The condition for starting to flow the current in a macroscopic view is determined as follows. That is, for instance, the energy barrier in Fig. 6d, in other words, the thickness $\alpha$ of the Schottky barrier which is the distance from the position of the junction in the energy band figure to the intersection between the Fermi level and the lower end line of the conduction band inclined due to the electric field of the semiconductor, is determined to approximately 100 angstrom. In the semiconductor device according to the present invention, as described above, the thickness of the energy barrier of the Schottky junction reverse-biased is modulated by the electric field of the gate electrode to control the tunnel phenomenon, thereby controlling the main current in the device.

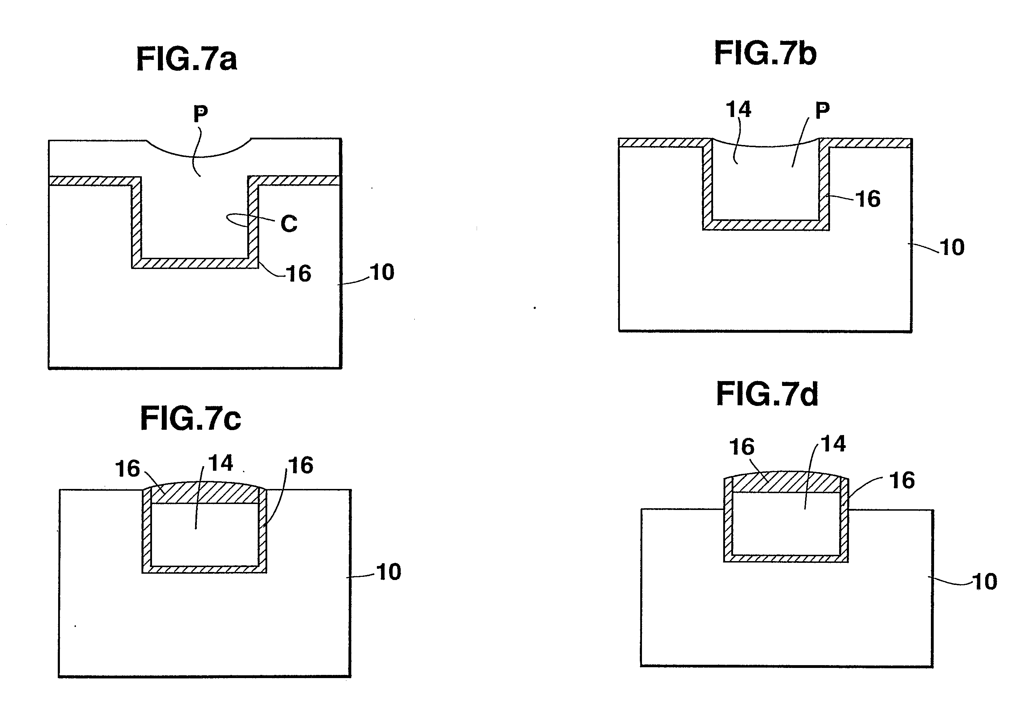

One embodiment of a method for producing the semiconductor device shown in Fig. 2 according to the present invention will now be described with reference to Figs. 7a to 7d.

First, as shown in Fig. 7a, a vertical groove C is formed in the surface area of a drain region 10 composed of an n-type silicon semiconductor substrate, and the surface portion of the grooved drain region 10 is oxidized to for an insulating gate oxide film 16 if formed. Then, a conductive polycrystalline silicon layer P is deposited over the surface of the drain region 10 to fill up the groove C with the polycrystalline silicon layer P. Then, the polycrystalline silicon layer P is etched so that the polycrystalline silicon layer P remains only in the groove C, as shown in Fig. 7b. The polycrystalline silicon layer P in the groove C will constitute a gate electrode 14.

Then, in Fig. 7c, the surface of the polycrystalline silicon layer P in the groove C is oxidized. Since the oxidizing rate of the polycrystalline silicon is more quick than that of the monocrystalline silicon constituting the drain region 10, the surface of the object shown in Fig. 7b is oxidized and then the resulted oxide film is etched to form the structure where the oxide film is formed only on the polycrystalline silicon layer P and the n-type silicon is exposed outside beside the oxide film, as shown in Fig. 7c. Then, only the n-type silicon substrate for the drain region 10 is etched in a suitable depth to form the structure shown in Fig. 7d. Then, a metallic material is deposited on the n-type silicon substrate to form a Schottky junction therebetween to form a semiconductor device according to the present invention, as shown in Fig. 2. When a plurality of semiconductor devices of this kind is integrated in parallel with one another, a large current can be flowed therein.

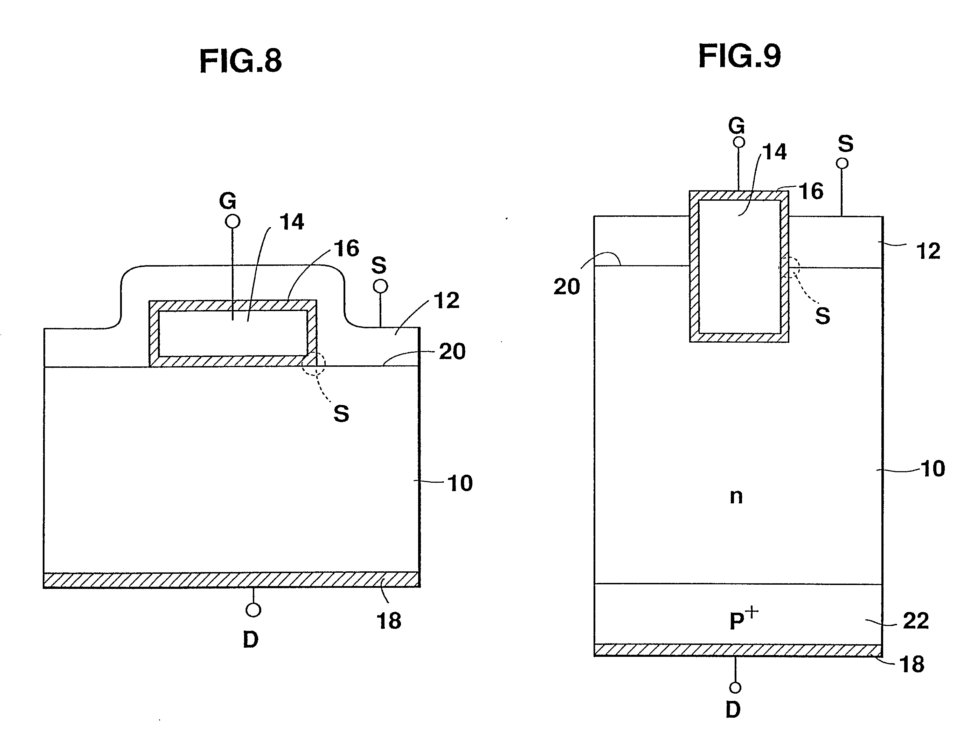

In Figs. 8 and 9, there are shown other embodiments of a semiconductor device according to the present invention.

In the embodiment shown in Fig. 8, a gate electrode 14 wholly covered by an insulating oxide film 16 is formed on the flat surface of a drain region 10 and as well as in a plane containing a Schottky junction 20 between the drain region 10 and a metallic source electrode 12. The metallic source electrode 12 entirely covers the gate electrode 14 covered by the insulating oxide film 16. In this embodiment, the gate electrode 14 covered by the insulating oxide film 16 is not projected into the drain region 10, and hence the semiconductor device can be produced easier in a simpler method than the one shown in Figs. 2 and 7. In this case, in a partial area S indicated by a broken circular line in Fig. 8, the metallic source electrode 12 may be lowered with a depth of approximately the same thickness of the side wall of the insulating oxide film 16 covering the gate electrode 14 to form the Schottky junction 20 right under the insulating oxide film 16, with the result of effective characteristics.

In the embodiment shown in Fig. 9, a $p^+$-type anode region 22 is further interposed between an n-type silicon drain region 10 and a drain electrode 18 in comparison with the embodiment shown in Fig. 2. In this embodiment, in the ON-state of the semiconductor device, the hole injection from the p-type anode region 22 into the drain region 10 is carried out, and a semiconductor device having a further lower ON-resistance can be obtained in virtue of the conductivity modulation effect. Furthermore, in this case, there is no parasitic thyristor which arises a problem in a conventional conductivity modulation type MOSFET (IGBT), and accordingly no latch-up phenomenon takes place.

From the above description, it is readily understood that there is no channel region of a conventional MOSFET in the semiconductor device according to the present invention, and the ON-resistance of the device can be reduced accordingly. This device can be operated as a voltage drive device in the same manner as a MOSFET. This device is of a normally off type, and its current-voltage characteristics are similar to those of a triode vacuum tube. Further, when the semiconductor device according to the present invention is produced, no impurity diffusion or doping step is required for preparing its main device structure, and thus it can be produced in a simpler manner than the conventional ones. Hence, when the devices are miniaturized or integrated, limitations are largely reduced. In the semiconductor device according to the present invention, in particular, no parasitic element is contained, and therefore error operations caused by the parasitic element can be exactly prevented.

## Claims

1. A semiconductor device, comprising:
a semiconductor substrate having a first conductivity type;
a metal electrode formed on the semiconductor substrate to form a Schottky junction therebetween; and
a gate electrode arranged adjacent to the Schottky junction via an insulating film.

2. The device of claim 1, wherein the gate electrode projects into the semiconductor substrate and projects outside across the metal electrode.

3. The device of claim 1, wherein the gate electrode is formed in a plane containing the Schottky junction.

4. The device of claim 1, wherein an anode region having a second conductivity type is formed on the semiconductor substrate in the opposite side of the metal electrode.

5. The device of claim 1, wherein the gate electrode is covered by the metal electrode.

6. The device of claim 1, wherein a voltage for strengthening a reverse bias of the Schottky junction is selectively applied to the gate electrode.

FIG.1 PRIOR ART

FIG.2

# FIG.3

# FIG.4a

# FIG.4b

# FIG.5

# FIG.6a

# FIG.6b

## FIG.6c

## FIG.6d

FIG.7a

FIG.7b

FIG.7c

FIG.7d

# FIG.8

# FIG.9

EP 0 348 916 A2